Europäisches Patentamt

(19) European Patent Office
Office européen des brevets

(11) Publication number: 0 222 404
A1

(12) # EUROPEAN PATENT APPLICATION

(21) Application number: 86115801.2

(22) Date of filing: 13.11.86

(51) Int. Cl.4: C30B 11/00 , C30B 35/00

(30) Priority: 15.11.85 US 798378

(43) Date of publication of application:
20.05.87 Bulletin 87/21

(84) Designated Contracting States:
FR GB IT NL SE

(71) Applicant: KOLLMORGEN TECHNOLOGIES
CORPORATION
Suite 300 2001 Bryan Tower
Dallas Texas 76201(US)

(72) Inventor: Allred, Worth P.
Ephraim Canyon Road
Ephraim Utah 84267(US)

(74) Representative: Königseder, geb. Egerer,
Claudia
Zugspitzstrasse 65
D-8104 Grainau(DE)

(54) Gallium arsenide crystals and process for growing same.

(57) A modified "Horizontal Bridgman" process for growing undoped compound single crystals, preferably GaAs crystals, is claimed. The crystal is grown in a boat (305) consisting of pyrolytic boron nitride covered with a layer of powdered $B_2O_3$ (310) or boric acid, thus achieving single crystals with less than 3000 dislocations or etch pits per cm² and a resistivity of $10^8$ ohm-cm or more, and a resistivity after conversion degradation of not less than $5 \times 10^6$ ohm-cm. In addition, the presence of a small amount of oxygen (340) for combining with silicon reduces silicon contamination of the formed GaAs crystals.

EP 0 222 404 A1

FIG. 2

# GALLIUM ARSENIDE CRYSTALS AND PROCESS FOR GROWING SAME

This invention relates to undoped compound crystals such as gallium arsenide undoped single crystals and the process for growing such crystals.

Compound crystals have been used in the semi-conductor industry for certain high performance uses in place of silicon crystals in integrated circuits and optical transducers. The preferred and most commonly used semi-conducting compound is gallium arsenide (GaAs). Other useful semi-conducting gallium compounds are gallium phosphide, gallium indium arsenide, gallium aluminum arsenide, gallium arsenide phosphide and gallium indium phosphide. Useful semi-conducting compounds also include compounds of class III elements (e.g. indium, aluminum and gallium) with class V elements (e.g. antiminides, phosphides and arsenides).

Semi-conducting compounds of class II elements (e.g. cadmium and zinc) with class VI elements (e.g. tellurides and sulphides) can be useful, too.

The compound semi-conductors, and particularly gallium arsenide, have a number of advantages over the more common silicon-based semi-conductors. Gallium arsenide has electron mobility on the order of 800 $cm^2/\mu sec$ and is as much as six times faster than silicon. GaAs semi-conductors have operated as fast as 60 GHz compared to 4 GHz for the fastest bipolar silicon devices. GaAs can be made highly resistive, above $10^7$ ohm-cm, to eliminate the need for siolation structures common in the silicon-based technology. GaAs exhibits a direct bandgap of 1.43 eV and is, therefore, excellent for use in light emitting diodes (LEDs) and other optical transducers. Unlike silicon-based semi-conductors, GaAs based semi-conductors have a high tolerance to radiation and are, therefore, ideal for military applications or other application involving radiation exposure.

The most common prior technique for growing GaAs crystal ingots has been by the liquid-encapsulated Czochralski (LEC) method in which a crystal is grown at high pressure and rotated slowly to encourage uniform growth as it is pulled from a melt. Approaches for improving the uniformity of bulk LEC-grown GaAs include (1) reducing the thermal gradient from the center to the outside of the crystal, (2) doping the melt with elements like indium, (3) growing the crystal in a magnetic field, and (4) automatically controlling the diameter of the crystal under computer control.

Another known method for growing gallium compound crystals is horizontal Bridgman (HB). The starting materials are placed in a "boat" within a fused silica reaction tube. The boats are generally made up of fused silica, alumina, aluminum nitride or boron nitride. The crystal is grown from a seed crystal as the boat passes through a furnace. In the horizontal Bridgman process as described in US patent 3 353 912, a quartz vessel or boat is loaded with gallium arsenide melt and a seed crystal. A Stoichiometric amount of arsenic and the loaded boat are placed in a quartz tube or ampoule. The arsenic is placed in one end of the ampoule. The seed crystal is used to initiate the crystal growth from the melt material in the boat. The ampoule is evacuated and sealed. The quartz ampoule is provided with an extra source of oxygen, e.g., gaseous $O_2$ or a metallic oxide. The zone of the ampoule containing the arsenic is heated to about 618°C and the zone containing the quartz boat is heated to about 1247°C, the melting point of the GaAs starting materials. The GaAs crystal grows from the seed crystal as the ampoule programs through a cooling temperature gradient.

US patent 3 623 905 describes a method of reducing the level of silicon contamination occurring in the HB process. According to the method described in this patent, an excess gallous oxide atmosphere is formed and a small amount of silicon, a silicon compound, a boron compound, or an aluminum compound is added to the boat. The silicon, boron or aluminum compounds are said to form an oxide surface film in order to suppress silicon contamination of gallium arsenide crystals. Although the addition of excess oxygen aids in suppressing silicon contamination, the resulting crystal nonetheless contains a significant amount of silicon.

US patent 3 649 192 describes a modification of the HB process for suppressing silicon contamination by introducing a small quantity of boron oxide into the quartz ampoule. The boron oxide is introduced in a boat separate from the boats containing gallium and arsenic in the reactor. Again, the GaAs crystals made according to this method are silicon-contaminated and display a high degree of resistivity degradation.

US patent 3 690 847 describes a method of making gallium arsenide crystals by a "two temperature" HB technique claiming to suppress silicon contamination. A quartz ampoule is loaded with two boats containing gallium. Arsenic is placed at one end of the ampoule. The ampoule is heated in the region of the first boat to a temperature slightly above the melting point of gallium arsenide. The region of the ampoule near the second boat is heated to a higher temperature, about 1250°C-1350°C, to initiate silicon dioxide formation near the second boat, away from the first boat. The GaAs crystal is formed upon cooling the ampoule. The crystals formed, again, display a high degree of resistivity degradation.

In US patent 4 169 755 a method of manufacturing a rod of semi-conductor material, such as GaAs, in a crucible formed at least partly of fibrous refractory material is described. Prior to use, fibrous silicon dioxide material is treated by wetting with gallium and then by heating at a temperature between 1150°C and 1200°C until the gallium has disappeared. The treated fibrous material is placed in a crucible. The crucible is then charged with GaAs, the GaAs melted and thereafter solidified. The GaAs crystals thus produced are found to be contaminated with silicon. Currently, undoped semi-conducting GaAs crystals for use in making FETs (field effect transistors) or MESFETs (Metal Schottky field effect transistors) are usually grown by the LEC process. The material from this process is generally characterized by a high dislocation density and high cost. In the LEC method as previously explained, the GaAs crystal is grown by vertical drawing from the surface of a pre-formed compound in the liquid state. One of the components of the crystal is volatile with a high reduction pressure at the melting point. Because of the volatile component, sufficient pressure must be maintained as the crystal is grown resulting in high dislocations and cost.

US patent 3 649 193 describes a method of making a semi-conductor compound such as GaAs according to the LEC process in which one of the compounds, e.g. gallium, is placed in a vessel having a porous portion. A second compound, e.g. arsenic, is vaporized and diffused in the first, liquid component. A layer of liquid boron oxide is placed over the surface of the liquid component to protect the surface of the liquid component from silicon contamination.

US patent 4 478 675 describes a modified LEC method of producing GaAs single crystals doped with boron. This patent describes a method in which GaAs crystals doped with boron are grown from a GaAs melt which is covered with $B_2O_3$ melt as a liquid encapsulant. The crucible in which the crystal is grown can be made of quartz, pyrolytic boron nitride, aluminum nitride or aluminum oxide.

The HB method, generally, has not been used in the past to produce undoped gallium arsenide crystals even though such crystals have lower dislocation densities than can be achieved with the LEC method. The prior crystals made by the HB method have been contaminated with silicon, thus decreasing initial resistivity and increasing resistivity degradation. In order to achieve the high resistivity (above $10^7$ ohm-cm) required in the field effect transistors, chromium doping has been required to absorb excess electrons. When chromium is added, however, the material tends to lose resistivity, or "converts", during subsequent heat treatment such as is required for ion implantation during the formation of the field effect transistors. For field effect devices the degradation should not reduce resistivity below $5 \times 10^6$ ohm-cm when the crystal is exposed to 850°C for 10 minutes in a hydrogen atmosphere. Thus, even though HB type gallium arsenide crystals generally have lower dislocation densities, they have not generally been usable in field effect transistors or MESFETs because of the resistivity degradation problem.

It is an object of this invention to provide a process for making undoped compound single crystals which are substantially free of dislocations and flaws.

Another object of this invention is to provide a process for growing undoped compound single crystals which are highly resistive and have little resistivity degradation during subsequent heat treatment.

It is a further object of this invention to provide a process capable of growing gallium arsenide crystals having a low number of dislocations, high resistivity and low resistivity degradation.

A still further object of the invention is to provide a gallium arsenide single crystal with few dislocations, high resistivity and little resistivity degradation in subsequent high temperature processing.

According to the invention, there is provided a horizontal Bridgman process for growing compound semi-conductive crystals wherein a compound starting material is loaded in a boat with an undoped seed crystal and the loaded boat placed within a quartz ampoule which is then sealed, said sealed ampoule being drawn through a furnace for heating to a temperature sufficient to melt said compound and grow a compound semi-conduction crystal from said seed crystal as said compound material cools, characterized in that the process comprises coating said boat made of a pyrolytic material not including silicon with a layer of boron oxide; placing the compound starting material in said coated pyrolytic material boat; melting said boron oxide during the heating step of said crystal growth process; and providing a sliding support for the growing crystal.

The undoped single crystals produced by the process of the invention have a low dislocation density, typically in the range between 1000-3000 etch pits/cm² and lower. The silicon contamination is low and initial resistivities are above $10^7$ ohm-cm, and typically above $2 \times 10^7$ ohm-cm, without the addition of chromium or similar additives. The crystals produced by the inventive process are substantially non-converting during subsequent heat treatment and maintain a resistivity above $5 \times 10^6$ ohm-cm even after exposure to 850°C for 30 minutes in a hydrogen atmosphere. The thus produced undoped GaAs crystals are excellent for use in making FETs and MESFETs.

Single crystal products according to the invention are grown by a modified HB technique wherein a fluid layer is provided between the growing crystal and the boat surface on which the crystal grows. This provides the growing crystal with a substantially frictionless medium on which to move as it grows, thereby reducing mechanical stress on the crystal caused by the difference in thermal expansion of the boat and the growing crystal.

In growing undoped GaAs crystals according to the invention, a pyrolytic boron nitride (PBN) boat is used rather than a quartz boat, in order to reduce the exposure of the growing crystal to silicon. The boat is coated with boron oxide by distributing powdered boron oxide ($B_2O_3$) or boric acid on the surface of the PBN boat or by oxidizing the PBN boat. At crystal growing temperatures, $B_2O_3$ provides a fluid layer on the surface of the boat which acts to produce a frictionless layer capable of reducing stress. The PBN boat is loaded with pre compounded gallium arsenide and a small amount of gallium oxide ($Ga_2O_3$). An undoped seed crystal is placed into the boat to initiate the crystal growth. The loaded boat is placed into a quartz ampoule, evacuated and sealed. The sealed ampoule is heated and then progressively cooled such that a single crystal grows from the seed crystal.

The boat is preferably a high temperature refractory material which does not include silicon. Such materials include PBN as mentioned above, or alumina, zirconia and magnesia. The boat preferably has a laminated surface permitting breakaway removal of the crystal ingot after formation and cooling.

Figure 1 is a cross-sectional view of a quartz ampoule loaded with gallium and arsenic preparatory to the step of compounding the gallium and arsenic into a solid ingot.

Figure 2 is a cross-sectional view of a quartz ampoule loaded with pre-compounded GaAs preparatory to growing on undoped GaAs crystals.

The undoped gallium arsenide crystals of this invention are made by a horizontal Bridgman (HB) method modified to reduce the thermal and mechanical stress placed on the crystals as they grow.

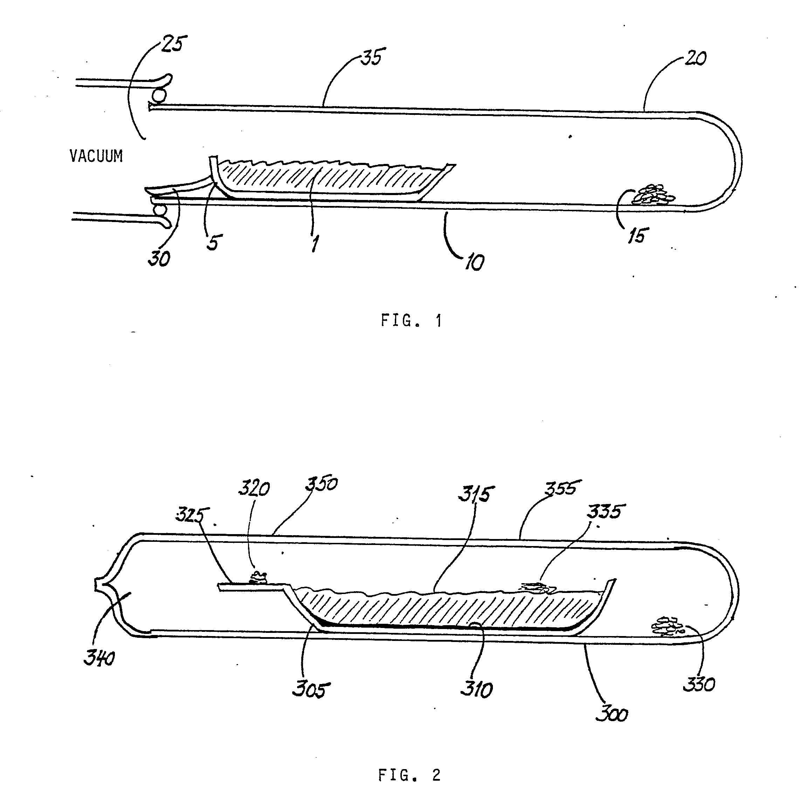

Figure 1 illustrates the ampoule used for pre-compounding gallium arsenide preparatory to growing a GaAs crystal. A GaAs ingot is formed as shown in Fig. 1 by placing gallium (1) in a quartz boat (5) which, in turn, is placed in quartz ampoule (10). A stoichiometric amount plus a slight excess of arsenic (15) is also placed in one end (20) of the quartz ampoule (10). The slight excess of arsenic should be sufficient to fill the vapor space in the quartz ampoule upon heating. The quartz ampoule (10) is then evacuated to about $1 \times 10^{-6}$ torr and sealed by collapsing the open end (25) of the ampoule (10) around a quartz plug with a high temperature torch. The ampoule is then heated in a Bridgman growth furnace. The arsenic zone (35) is heated to at least about 1249°C. The gallium and arsenide are heated for about three hours and form a liquid compound in quartz boat (5). The liquid GaAs is then progressively cooled by slowly moving through the furnace, causing the melt to progressively solidify into an ingot of pre-compounded GaAs material.

Compounding can also take place during the crystal growing process by placing gallium only in the boat, and an amount of arsenic in slight excess of the stoichiometric quantity in the quartz ampoule outside the boat. An additional temperature control is then required during the growth process to maintain the arsenic zone of the ampoule at about 618°C as as to sublime the arsenic, providing 1 atm. of arsenic gas pressure in the ampoule. The other zone of the ampoule furthest away from the seed crystal is heated above the GaAs melting point. As the ampoule moves through the carefully controlled temperature zones, the GaAs compound is formed and the molten compound then progressively cools to form a single crystal.

Figure 2 depicts a sealed quartz ampoule (300) used for growing undoped GaAs crystals according to the process of the invention. To make undoped, semi-insulating GaAs crystals, consideration must be given to preventing silicon from entering the crystal structure. To minimize silicon contamination, instead of the usual quartz boat, a boat made of a high temperature refractory material, preferably a PBN boat, is used.

As can be seen in Figure 2, the pyrolytic boron nitride (PBN) boat (305) is coated with a layer of boron oxide ($B_2O_3$) (310). This layer can be formed using boron oxide powder or boric acid powder. At the crystal growth temperatures, the $B_2O_3$ becomes molten and provides a substantially frictionless surface on which the growing crystal can glide. This considerably reduces the mechanical stresses placed on the crystal as it grows.

Pre-compounded GaAs (315) is placed on the coated surface of the PBN boat (305). An undoped GaAs seed crystal (320) is placed in the spoon section (325) of the boat (305). An excess of arsenic (330) is placed in the closed end of the quartz ampoule (300). The loaded PBN boat (305) is also placed in the quartz ampoule (300).

A small amount of $Ga_2O_3$ (335) is placed in the boat (305) to act as an oxygen source during the growing process. Alternatively, arsenic oxide can also be used as an oxygen source. The $B_2O_3$ also provides an oxygen source. Oxygen from these sources reacts with silicon to form $SiO_2$ which floats on the melt surface during the growth process and, therefore, does not enter the GaAs crystal lattice. A small amount of oxygen gas (340) may also be placed into the ampoule to form $GaO_3$ and act as a "getter" reducing silicon contamination in the melt.

The quartz ampoule (300) is evacuated and sealed and then passed through a double furnace. Furnace zone (350) in the direction of seed crystal (320) is heated to about 1219°C, i.e., 30°C below the melting point of GaAs. Furnace zone (355) away from the seed crystal is maintained at a temperature of about 1279°C to maintain the molten state of GaAs. As the crystal begins to form, the crystal/melt interface between the furnaces is maintained at 1249°C. The ampoule is slowly moved such that the crystal/melt interface moves slowly across the boat. Preferably, the temperature gradient between furnaces is kept fairly small. The ampoule (300) is moved slowly toward the lower temperature furnace to grow a single crystal of GaAs. Undoped gallium arsenide crystals according to the invention are particularly useful in making field-effect transistors (FETs) and metal Schottky FETs (MESFETs). For these applications the gallium arsenide crystals and wafers made from the crystals must have high initial resistivity and must maintain a high resistivity during subsequent heat treatment steps. Many crystals with high initial resistivity, such as chromium-doped crystals, have a tendency to lose resistivity when exposed to heat. This resistivity degradation is often termed "conversion".

Conversion can be tested by placing clean polished wafers made of the GaAs single crystal in a quartz tube with an amount of arsenic sufficient to fill the vapor space in the tube when heated. The tube is evacuated to a pressure of $10^{-6}$ torr, sealed and heated to about 850°C for about 30 minutes in a hydrogen atmosphere. The resistivity of the crystals after this treatment should be at least $5 \times 10^6$ ohm-cm.

Another important attribute of semi-conducting GaAs crystals is the number of dislocations per unit area of the crystal. This dislocation density is measured by etching a polished cut crystal surface with a heated strong mineral base, such as potassium hydroxide, and then examining microscopically. The number of pits etched by the base in the surface of the crystal per unit area of crystal surface and indicative of dislocations are counted. In crystals for commercial use the dislocation density should be below 3000 etch pits/cm², and preferably 1000 etch pits/cm².

## EXAMPLE

(a) Precompounding GaAs

Gallium (1 307.8 g) was placed in a quartz boat. The boat was placed in a fused silica - (quartz) ampoule having a 3 700 ml capacity. Arsenic (1 404.9 g) was also placed in the quartz ampoule. The ampoule was evacuated to a pressure of $1 \times 10^{-7}$ torr and then sealed. The ampoule was heated in a horizontal Bridgman crystal grower as follows: The zone surrounding the arsenic was heated to a temperature of 616°C, and the zone surrounding the boat was heated to a temperature of 1250°C for a period of three hours. The ampoule was moved out of the oven at a rate of 1 cm/hr such that the crystal grew within 24 hours. A 2 709 g solid ingot of GaAs formed in the boat.

(b) Undoped GaAs Cystal

The surface of a PBN boat was coated with 15 g of $B_2O_3$ to form a substantially uniform layer of $B_2O_3$ on the boat. A solid ingot of precompounded GaAs made according to (a) weighing 2 600 g was placed in the coated PBN boat. A GaAs seed crystal was placed in the spoon of the boat. Additional arsenic (0.89 g) was placed into the end zone of a 2000 ml quartz ampoule. The boat loaded with GaAs was further loaded with 0.05 g of $Ga_2O_3$ and placed into the ampoule. The ampoule was evacuated to a pressure of $1 \times 10^{-7}$ torr and sealed. The ampoule was heated in a double furnace. The zone of the ampoule away from the seed crystal was maintained at 1265°C. The zone of the ampoule closest to the seed crystal into which the ampoule moved, i.e., the leading zone, was maintained at 1235°C. The ampoule was then moved through the furnaces at a rate of 1 cm/hr.

The GaAs crystal grown thereby had about 2000 etch pits/cm², and an initial resistivity of $5 \times 10^8$ ohm-cm. Upon heat treatment at 850°C for 30 minutes in a hydrogen atmosphere, only minor resistivity degradation was noted reducing resistivity to $2 \times 10^8$ ohm-cm.

## Claims

1. A horizontal Bridgman process for growing compound semi-conductive crystals wherein a compound starting material is loaded in a boat with an undoped seed crystal and the loaded boat placed within a quartz ampoule which is then sealed, said sealed ampoule being drawn through a furnace for heating to a temperature sufficent to melt said compound and grow a compound semiconduction crystal from said seed crystal as said compound starting material cools, **characterized** in that the process comprises coating said boat made of a pyrolytic material not including silicon with a layer of boron oxide; placing the compound starting material in said coated pyrolytic material boat; melting said boron oxide during the heating step of said crystal growth process and providing a sliding support for the growing crystal.

2. The process of claim 1 wherein said compound starting material is gallium arsenide and wherein said process grows undoped gallium arsenide single crystals.

3. The process of claims 1 or 2 wherein said boat is made of a material selected from the group including pyrolytic boron nitride, alumina, zirconia and magnesia.

4. The process of claim 3 wherein said boat is made of pyrolytic boron nitride.

5. The process of claims 1, 2 or 3 wherein said boat has a laminated surface structure permitting break-away removal of the crystal ingot after formation and cooling.

6. The process of claims 1 to 5 wherein said boron oxide also provides a source of oxygen for combining with silicon present thus reducing silicon incorporation into the crystal lattice.

7. The process of claim 2 wherein additional gallium oxide or arsenic oxide is placed in said ampoule to provide an oxygen source for combining with silicon present thus reducing silicon incorporation into the crystal lattice.

8. The process of claim 1 wherein oxygen gas is placed in said ampoule to provide an oxygen source for combining with silicon present thus reducing silicon incorporation into the crystal lattice.

9. The process of claim 2 wherein said gallium arsenide starting material is compounded in the same ampoule used for said crystal growth.

10. The process of claim 2 wherein said gallium arsenide starting material is separately precompounded and then placed in said ampoule.

11. The process of claim 9 wherein an excess of arsenic is placed in said ampoule.

12. A gallium arsenide, undoped single crystal made by the process of one or more of claims 2 to 11 having an initial resistivity of at least $10^7$ ohm-cm, and preferably above $10^8$ ohm-cm, a resistivity after conversion degradation of no less than $5 \times 10^6$ ohm-cm, and preferably no less than $1 \times 10^8$ ohm-cm, and a dislocation density below 3000 etch pits/cm², and preferably below 2000 etch pits/cm².

FIG. 1

FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 104 741 (WESTERN ELECTRIC) <br> * Claims 1-7; pages 8-10 * | 1-4,9-12 | C 30 B 11/00 <br> C 30 B 35/00 |
| | --- | | |
| X | DE-A-1 959 392 (WACKER-CHEMITRONIC) <br> * Claims * | 1-4 | |
| | ----- | | |

**TECHNICAL FIELDS SEARCHED (Int. Cl.4)**

C 30 B 11/00
C 30 B 35/00

The present search report has been drawn up for all claims

| Place of search | Date of completion of the search | Examiner |
|---|---|---|
| THE HAGUE | 11-02-1987 | BRACKE P.P.J.L. |

EPO Form 1503 03 82